Europäisches Patentamt

European Patent Office

Office européen des brevets

(19)

(11) Publication number: **0 140 369**

**A1**

(12) # EUROPEAN PATENT APPLICATION

(21) Application number: **84113062.8**

(22) Date of filing: **30.10.84**

(51) Int. Cl.⁴: **H 01 L 27/08**

(30) Priority: **02.11.83 JP 204830/83**

(43) Date of publication of application:
**08.05.85 Bulletin 85/19**

(84) Designated Contracting States:
**DE FR GB NL**

(71) Applicant: **HITACHI, LTD.**
**6, Kanda Surugadai 4-chome Chiyoda-ku**
**Tokyo 100(JP)**

(72) Inventor: **Kaneko, Kenji**
**2609-11, Shimokuzawa**
**Sagamihara-shi Kanagawa-ken(JP)**

(72) Inventor: **Nakamura, Tohru**
**6-6-16-614, Minami-machi**
**Tanashi-shi Tokyo(JP)**

(72) Inventor: **Okabe, Takahiro**
**2196-36, Hinodemachi Hirai**
**Nishitama-gun Tokyo(JP)**

(72) Inventor: **Nagata, Minoru**
**1558, Josuihoncho**
**Kodaira-shi Tokyo(JP)**

(74) Representative: **Patentanwälte Beetz sen. - Beetz jun.**
**Timpe - Siegfried - Schmitt-Fumian**
**Steinsdorfstrasse 10**
**D-8000 München 22(DE)**

(54) **Semiconductor integrated circuit including series connected transistors.**

(57) According to a semiconductor integrated circuit of the present invention, a normal transistor ($Q_2$; $Q_4$) and an inverse transistor ($Q_1$; $Q_3$) are formed in a single isolated region, and both the bipolar transistors are connected in series and used in the integrated circuit, thereby to enhance the density of integration.

Besides, in the semiconductor integrated circuit of the present invention, the collector region of the normal transistor ($Q_2$; $Q_4$) and the emitter region of the inverse transistor ($Q_1$; $Q_3$) are disposed as a common region.

FIG. 4

## Title of the Invention

Semiconductor Integrated Circuit Including Series
Connected Transistors

## Background of the Invention

The present invention relates to semiconductor
integrated circuits, and more particularly to a semiconductor
integrated circuit including a circuit in which a plurality
of bipolar transistors are connected in series.

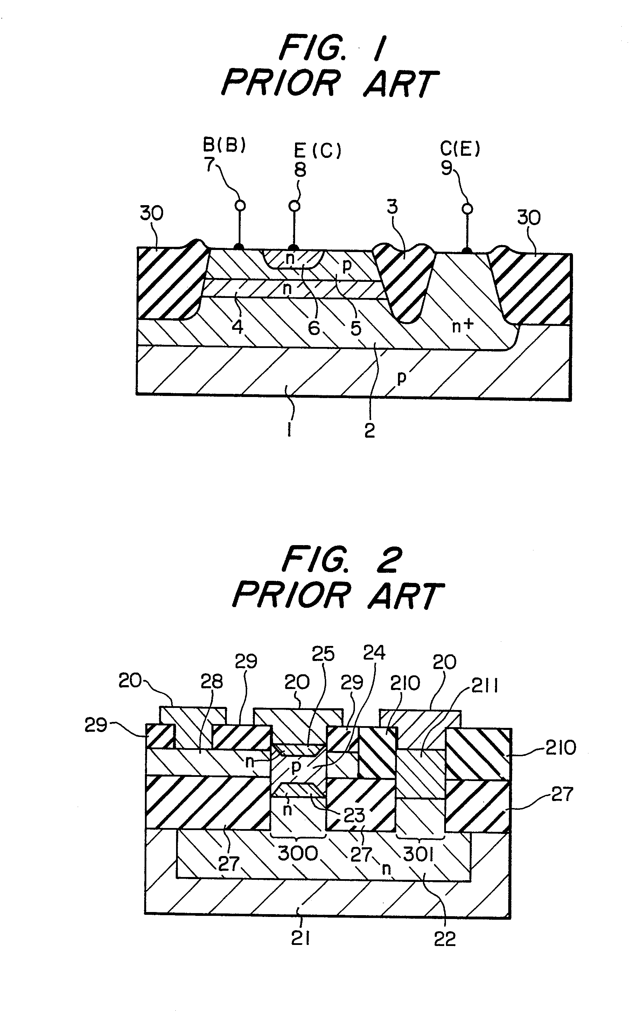

The structure of a bipolar transistor in a prior-
art integrated circuit is shown in Fig. 1 by taking
an n-p-n transistor as an example.

Referring, to Fig. 1, numeral 1 designates a semiconductor
substrate of p-type conductivity, numeral 2 a semiconductor
region of $n^+$-type conductivity (highly doped buried
region), numerals 3 and 30 insulator films, numeral
4 a semiconductor layer of n-type conductivity, numeral
5 a semiconductor layer of p-type conductivity, numeral
6 a semiconductor layer of n-type conductivity, and
numerals 7, 8 and 9 electrode terminals.  In a case
where the transistor in Fig. 1 is to perform its normal
operation, the terminal 8 is used as an emitter and
the terminal 9 as a collector.  On the other hand, in
a case where it is to perform its inverse operation,
the terminal 8 is used as a collector and the terminal
9 as an emitter.  The terminal 7 is used as a base in

- 2 -

0140369

both the cases. With the conventional bipolar transistor of such structure, the performance of the inverse operation has been much inferior to that of the normal operation. In the prior-art integrated circuit, therefore, only the transistor of the normal operation has been used in most cases.

Summary of the Invention

Many of various circuits have the circuit form in which bipolar transistors are stacked in series connection. In such case, the bipolar transistors of the normal operation have heretofore been connected in series. The reason is that. only the normal transistors have been capable of fulfilling the performance required of the circuit. The normal operation transistors, however, need to be isolated individually and are low in the density of integration. The present invention has for its object to eliminate this disadvantage and to provide a bipolar transistor series connection structure of high integration density.

According to the semiconductor integrated circuit of the present invention, a normal transistor and an inverse transistor are formed in a single isolated region, and both the bipolar transistors are connected in series and used in the integrated circuit, whereby enhancement in the density of integration is achieved.

- 3 -

0140369

Besides, in the semiconductor integrated circuit of the present invention, the collector region of a normal transistor and the emitter region of an inverse transistor are disposed as a common region.

## Brief Description of the Drawings

Fig. 1 is a sectional view showing the structure of an n-p-n transistor in a prior-art integrated circuit.

Fig. 2 is a sectional view showing the structure of an n-p-n transistor whose performances in both the normal and inverse operations are substantially equal.

Fig. 3A is a circuit diagram showing a series-connected transistor circuit.

Fig. 3B is a sectional view showing a structure in which the circuit of Fig. 3A is constructed of known transistors.

Fig. 4 is a sectional view showing a structure in which the circuit of Fig. 3A is constructed in accordance with the present invention.

Fig. 5A is a layout pattern plan of a transistor series-connection structure based on the prior-art construction in Fig. 3B.

Fig. 5B is a layout pattern plan of a transistor series-connection structure based on the construction of the present invention in Fig. 4.

Fig. 6, Fig. 8, Fig. 9, Fig. 10, Fig. 11, Fig. 12A, Fig. 12B and Fig. 13 are circuit diagrams showing examples of various circuits each of which includes the series connection circuit of transistors.

Fig. 7A is a layout pattern plan of the differential amplifier in Fig. 6 according to the prior-art construction.

Fig. 7B is a layout pattern plan of the differential amplifier in Fig. 6 according to the construction of the present invention.

Description of the Preferred Embodiments

Embodiments of the present invention will be described below.

Fig. 2 shows a structural section of a transistor which has been disclosed in Japanese Laid-open Patent Application No. 56-1556 (corresponding to U. S. Application Serial No. 443554 and West-German Patent Application Laying-open No. 3022565). In Fig. 2, numeral 25 designates an n-type semiconductor layer, numeral 24 a p-type semiconductor layer, and numeral 23 an n-type semiconductor layer. These semiconductor layers are provided in a convex portion 300 formed by etching a single crystal substrate 21. They function as the emitter (collector), base and collector (emitter) of the transistor, respectively, and construct the active regions of the transistor. Numeral 22 indicates an n-type semiconductor layer (buried layer) provided in the p-type semiconductor substrate 21.

The n-p-n transistor is formed of these semiconductor layers. In addition, a base terminal is led out from the side surface of the base layer 24 within the convex portion 300 by a polycrystalline silicon layer 28, under which an insulator layer 27 is formed. Further, in Fig. 2, numerals 29 and 210 denote insulator layers, numeral 211 an n-type semiconductor layer provided in another convex portion 301, and numerals 20 electrodes. The feature of this transistor is that, since a part having been a parasitic base (extrinsic base: base portion outside the active regions of a transistor) in the conventional transistor is formed of the polycrystalline silicon layer 28 as shown in Fig. 2, an unnecessary base part is scarcely included. This is greatly contributive to enhancements in the performances of the transistor. Particularly in case of using the conventional / transistor in the inverse operation, the performance of the transistor is drastically degraded by the evil effect of the parasitic base part. Therefore, the transistor including almost no parasitic base part as in the structure of Fig. 2 is very excellent in the performance of the inverse operation. Further, since the transistor of this structure is formed to be substantially symmetric in the vertical direction thereof, the performances of the operations

in both the normal and inverse directions have almost no difference.

The present invention concerns an integrated circuit arrangement which is assembled on the basis of elements having the structure of Fig. 2.

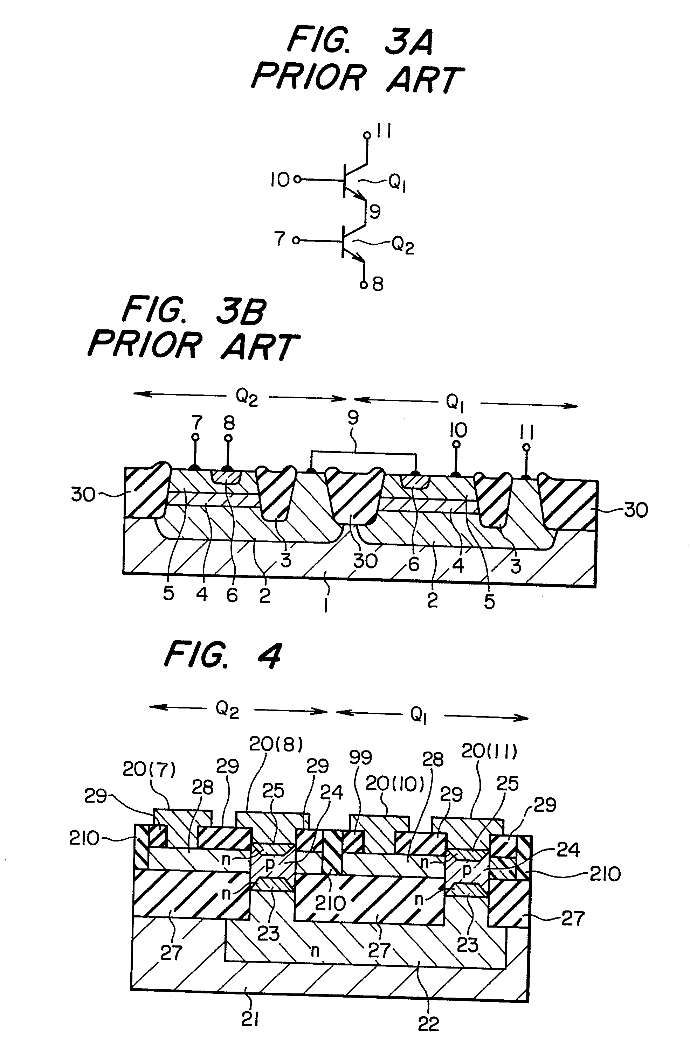

Figs. 3A and 3B show an example of the series connection of n-p-n transistors which is used in many of prior-art circuits.

In case of using the n-p-n transistors in series connection in the form illustrated in Fig. 3A, both the transistors Q1 and Q2 have been formed in individual isolated regions enclosed with an insulator layer 30 as shown in Fig. 3B. In such case, accordingly, the plurality of isolated regions are required, and the respective terminals of both the transistors Q1 and Q2 need to be led out and wired, so that the area per element becomes large.

According to the present invention, as a method for forming the series connection of the transistors shown in Fig. 3A, either transistor Q1 or Q2 is used as a normal operation transistor, and the other as an inverse operation transistor. Such an embodiment is shown in Fig. 4. In this embodiment, transistors of the structure illustrated in Fig. 2 are employed. When, as shown in Fig. 4, the transistor Q2 is used as the normal operation transistor and the transistor Q1 as
the inverse operation transistor, the collector of the
transistor Q2 and the emitter of the transistor Q1 become
a common region.  This brings forth the advantage that
the two transistors can be formed in a single isolation
region.  Further, in the prior-art example of Fig. 3B,
the emitter terminal of the transistor Q1 and the collector
terminal of the transistor Q2 are respectively led out
and wired.  In contrast, in the present invention, they
are dispensed with, and it becomes possible to enhance
the density of integration.

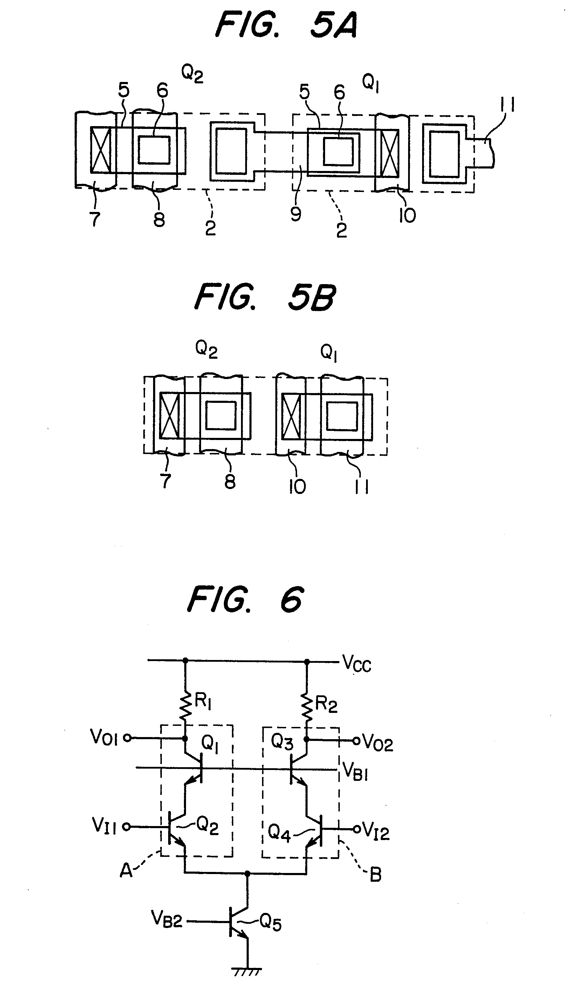

Plan views shown in Fig. 5A and Fig. 5B are layout
pattern plans of the series connection structures of
the transistors shown in Fig. 3B and Fig. 4, respectively.
As understood from this example, with the transistors
of the prior art shown in Fig. 5A, terminals for connecting
the respective transistors need to be led out, so that
the area per element becomes large.  When compared with
the prior art, the present invention in Fig. 5B has
the advantage that the area per element may be about $\frac{1}{2}$.

Since, in the present invention, the transistors
of the structure shown in Fig. 2 are employed, the structure
as illustrated in Figs. 4 and 5B is permitted.  Now,
the embodiments of application circuits each of which
employs the series connection of the transistors as

- 8 -

0140369

shown in Figs. 4 and 5B will be explained, and the validness of the present invention will be more emphasized.

Fig. 6 shows an example of a differential amplifier circuit. An ordinary differential amplifier circuit is constructed of transistors Q2, Q4, loads R1, R2, and a transistor Q5 for a constant current source ($V_{B2}$ indicates a D.C. bias voltage). When inputs ($V_{I1}$, $V_{I2}$) enter the bases of the differential pair of transistors so as to amplify the signals, outputs are derived from the collectors of the input transistors, and hence, the frequency characteristics degrade due to feedback to the input sides ascribable to the base-collector capacitances. To the end of preventing this, a method is adopted in which grounded-base transistors Q1, Q3 are inserted between the loads and the collectors of the differential pair of input transistors as illustrated in Fig. 6 ($V_{B1}$ indicates a D.C. bias voltage). Thus, output signals ($V_{01}$, $V_{02}$) are fed back only to the base sides ($V_{B1}$) of the transistors Q1, Q3 and are not fed back to the input sides of the differential pair of transistors Q2, Q4. Therefore, the frequency characteristics of this circuit are enhanced. In case of this circuit, each of the transistor pair A of Q1, Q2 and the transistor pair B of Q3, Q4 is the series connection of the transistors shown in Fig. 3A. Accordingly, the construction shown in Fig. 4 can be employed as each transistor pair in this circuit, and the integration density of the circuit can be enhanced without spoiling the performance of the circuit as explained with reference to Figs. 4 and 5B. In Fig. 6, $V_{CC}$ denotes a power source voltage.

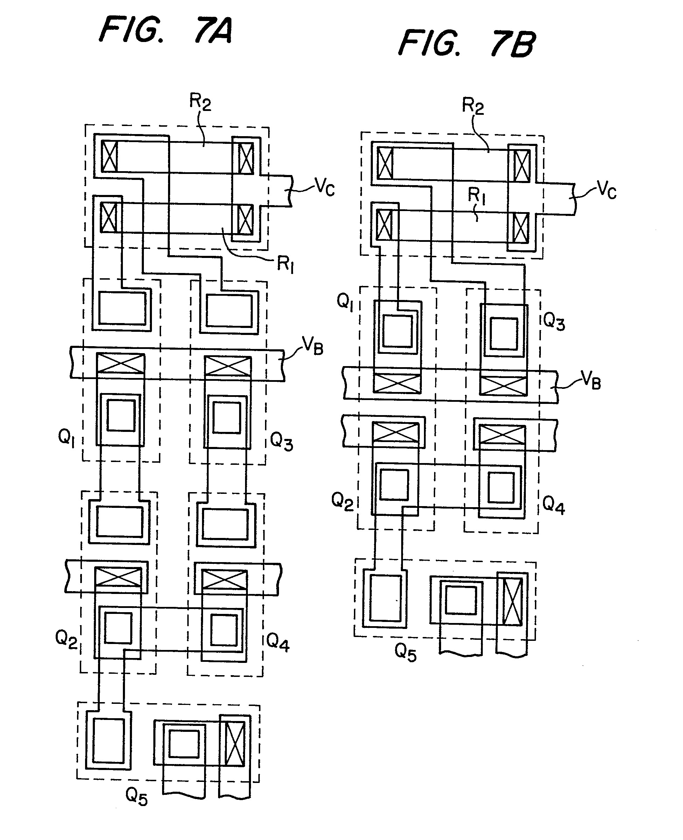

Fig. 7A and Fig. 7B show examples of layout pattern plans of the circuit in Fig. 6. Fig. 7A shows an example based on the prior-art construction, while Fig. 7B shows an embodiment based on the present invention. Advantageously, the circuit area of the embodiment according to the present invention may be about 80 % of that of the prior-art example.

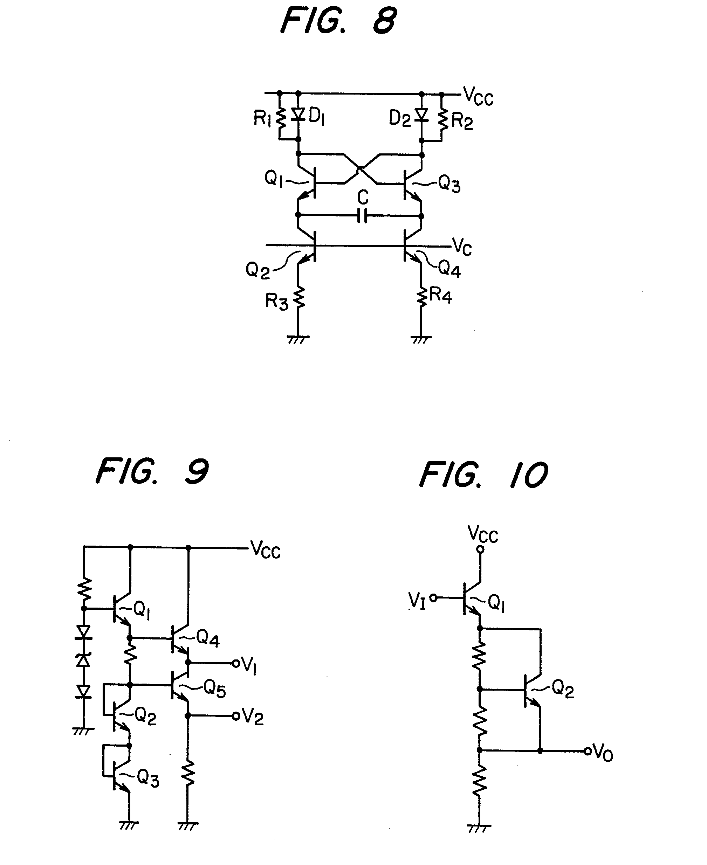

Fig. 8 shows an example of an emitter coupled multivibrator. Also in this circuit, the transistors Q1, Q2 and Q3, Q4 are connected in series as in the embodiment of Fig. 6. Therefore, the construction of the transistor pair shown in Fig. 4 can be employed, and the integration density of the circuit can be enhanced without spoiling the arrangement of the circuit. $V_C$ denotes a control voltage for an oscillation frequency.

Fig. 9 shows an example of a constant voltage source. In this circuit, transistors Q4, Q5 for providing output voltages V1, V2 are connected in series, so that the construction of the transistor pair shown in Fig. 4 can be employed. In addition, diode-connected transistors Q2, Q3 are series connected transistors, so that the construction shown in Fig. 4 can also be employed in this portion.  In an analog circuit, the series connection of diodes is often used in various places in order to adjust the levels of signals.  The present invention is applicable in such cases.

Fig. 10 shows an example of a level shift circuit. In this circuit, transistors Q1, Q2 are connected in series to the end of level-shifting an input voltage $V_I$ to an output voltage $V_0$.  Therefore, the construction of the transistor pair shown in Fig. 4 can be employed.

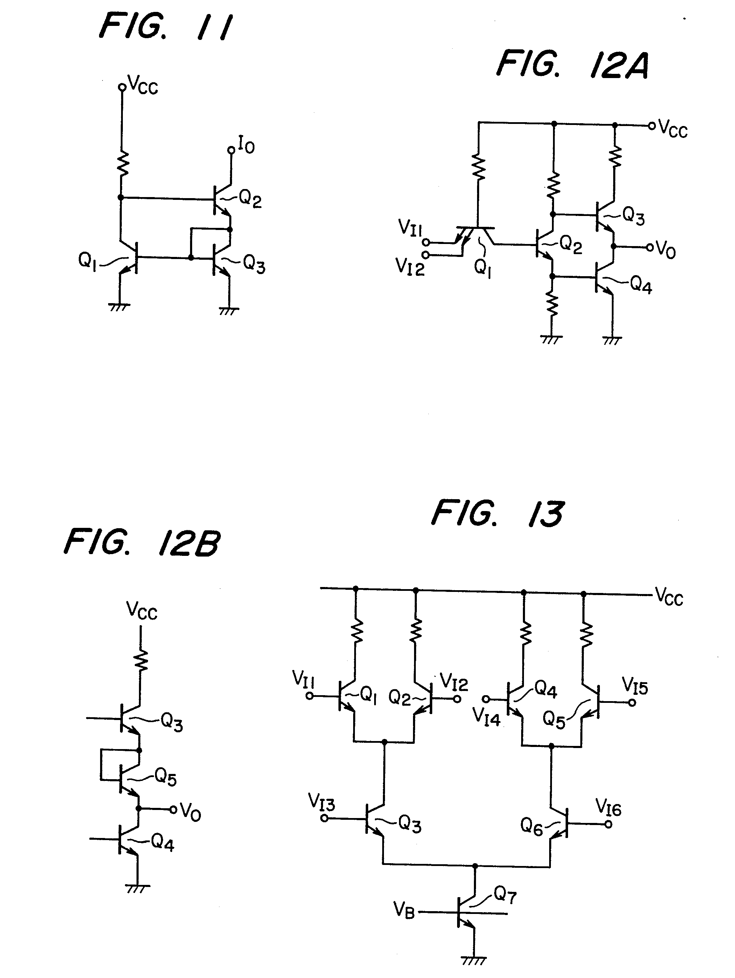

Fig. 11 shows an example of a constant current source.  Since a transistor Q2 and a diode-connected transistor Q3 are connected in series, the present invention is applicable.  $I_0$ indicates a constant current output.

Fig. 12A shows an example of a notoriously known TTL circuit.  Since the transistors Q3, Q4 of an output stage are connected in series, the present invention is applicable to this portion.  $V_{I1}$ and $V_{I2}$ denote input voltages, and $V_0$ an output voltage.  Besides, Fig. 12B illustrates a case where only the output stage in Fig. 12A is put into a different circuit form.  In this case, the present invention is applicable to the series connection of a diode-connected transistor Q5 and the transistor Q3 or the series connection of the transistors Q5 and Q4. Apart from this embodiment, a pair of series connected transistors are often used in an output stage within an integrated circuit, and the present invention is readily applied in such cases.

Fig. 13 shows a circuit which is often used in an ECL circuit or a Gilbert multiplier cell. While, in the foregoing embodiments, the series connection consisting of the two transistors has been referred to, the present invention is also applicable to a case of series connection which consists of the parallel connection of transistors Q1, Q2 (or Q4, Q5) and a transistor Q3 (or Q6) as in this embodiment. In this manner, as long as at least one portion of the series connection of transistors is existent, the present invention is applicable without being restricted as to the number of transistors which are connected in the portion.

As the embodiments have thus far been mentioned and described, the form of the series connection of transistors in the present invention has been employed in various circuits, and the advantage of the present invention that the area per element can be reduced without spoiling the performance can be demonstrated in a wide range of circuit fields. It is therefore believed that the invention has a very great value in industry.

What is claimed is:

1. A semiconductor integrated circuit including series connected transistors ($Q_1$, $Q_2$; $Q_3$, $Q_4$), comprising a series connection circuit which is composed of a first transistor ($Q_2$; $Q_4$) and a second transistor ($Q_1$; $Q_3$) and in which a collector of said first transistor ($Q_2$; $Q_4$) and an emitter of said second transistor ($Q_1$; $Q_3$) are formed as a common region.

2. A semiconductor integrated circuit including series connected transistors as defined in Claim 1, wherein a plurality of such series connection circuits (A, B) are disposed.

3. A semiconductor integrated circuit including series connected transistors as definded in Claim 1,wherein said first transistor ($Q_2$) is disposed as a normal transistor, and said second transistor ($Q_1$) as an inverse transistor.

4. A semiconductor integrated circuit including series connected transistors as defined in Claim 1, wherein said first and second transistors ($Q_1$; $Q_2$) are transistors in which a polycristalline semiconductor layer (28) provided on a side of a base region (24) is used as an electrode lead-out region.

## FIG. 1
## PRIOR ART

## FIG. 2
## PRIOR ART

2/6

0140369

# FIG. 3A
# PRIOR ART

# FIG. 3B
# PRIOR ART

# FIG. 4

## FIG. 5A

## FIG. 5B

## FIG. 6

0140369

FIG. 7A

FIG. 7B

0140369

# FIG. 8

# FIG. 9

# FIG. 10

FIG. 11

FIG. 12A

FIG. 12B

FIG. 13

## 0140369

## EUROPEAN SEARCH REPORT

. Application number

EP 84 11 3062

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int. Cl 4) |
| X | IBM TECHNICAL DISCLOSURE BULLETIN, vol. 12, no. 9, February 1970, page 1516, New York, US; H.D. VARADARAJAN: "Load impedance for transistor circuit" * whole article * | 1,3 | H 01 L 27/08 |
| X | IBM TECHNICAL DISCLOSURE BULLETIN, vol. 14, no. 6, November 1971, page 1684, New York, US; H. FRANTZ et al.: "Monolithic electric circuit" * whole article * | 1,3 | |
| A,D | DE-A-3 022 565 (HITACHI LTD.) * figure 2B; claim 3 * | 4 | |
| | ----- | | TECHNICAL FIELDS SEARCHED (Int. Cl.4) |
| | | | H 01 L |

The present search report has been drawn up for all claims

| Place of search THE HAGUE | Date of completion of the search 19-12-1984 | Examiner CARDON A. |
|---|---|---|